# EUROPÄISCHE PATENTSCHRIFT

(11) **EP 0 519 299 B1**
(45) Veröffentlichungstag und Bekanntmachung des Hinweises auf die Patenterteilung: **11.08.1999**
(21) Anmeldenummer: 92109653.3
(22) Anmeldetag: 09.06.1992
(51) Int. Cl.: G03F 7/004, G03F 7/075

(54) **Positiv arbeitendes strahlungsempfindliches Gemisch und damit hergestelltes strahlungsempfindliches Aufzeichnungsmaterial**
Positive-working radiation-sensitive composition and radiation-sensitive recording material produced therewith
Composition positive sensible aux radiations et matériel d'enregistrement réalisé à partir de cette composition

(30) Priorität: 19.06.1991 DE 4120173
(43) Veröffentlichungstag der Anmeldung: 23.12.1992
(73) Patentinhaber: Clariant GmbH, 65929 Frankfurt am Main (DE)
(72) Erfinder: Pawlowski, Georg, Dr., W-6200 Wiesbaden (DE); Röschert, Horst, Dr., W-6531 Ober Hilbersheim (DE); Spiess, Walter, Dr., W-6110 Dieburg (DE); Przybilla, Klaus-Jürgen, Dr., W-6000 Frankfurt am Main 1 (DE)

(56) Entgegenhaltungen:
- DE-A- 3 601 264
- FR-A- 2 389 157

## Beschreibung

Die Erfindung betrifft ein positiv arbeitendes strahlungsempfindliches Gemisch mit
a) einer Verbindung, die unter Einwirkung von aktinischer Strahlung starke Säure bildet,
b) einer Verbindung mit mindestens einer durch Säure spaltbaren C-O-C- oder C-O-Si-Bindung und
c) einem in Wasser unlöslichen, in wäßrig-alkalischen Lösungen löslichen oder zumindest quellbaren polymeren Bindemittel.

Die Erfindung betrifft weiterhin ein damit hergestelltes strahlungsempfindliches Aufzeichnungsmaterial, das zur Herstellung von Photoresists, elektronischen Bauteilen, Druckplatten oder zum Formteilätzen geeignet ist.

Die stetige Verkleinerung der Strukturen, beispielsweise in der Chip-Herstellung bis in den Bereich von weniger als 1 µm, erfordert veränderte Lithographietechniken. Um solche feinen Strukturen abzubilden, verwendet man Strahlung mit einer kurzen Wellenlänge, wie energiereiches UV-Licht, Elektronen- und Röntgenstrahlen. Das strahlungsempfindliche Gemisch muß an die kurzwellige Strahlung angepaßt sein. Eine Zusammenstellung der an das strahlungsempfindliche Gemisch gestellten Forderungen ist in dem Aufsatz von C.G. Willson "Organic Resist Materials - Theory and Chemistry" [Introduction to Microlithography, Theory, Materials, and Processing, Herausgeber L.F. Thompson, C.G. Willson, M.J. Bowden, ACS Symp. Ser., 219, 87 (1983), American Chemical Society, Washington] angegeben. Es bestand daher ein verstärkter Bedarf an strahlungsempfindlichen Gemischen, die in den neueren Technologien, wie der Mid- oder Deep-UV-Lithographie, [Belichtung z. B. mit Excimer-Lasern bei Wellenlängen von 305 nm (XeF), 248 nm (KrF), 193 nm (ArF)], der Elektronen- oder der Röntgenstrahl-Lithographie, einsetzbar sind, vorzugsweise darüber hinaus in einem weiten Spektralbereich empfindlich sind und dementsprechend auch in der konventionellen UV-Lithographie verwendet werden können.

Gemische, die neben einem in Wasser unlöslichen, in wäßrig-alkalischen Lösungen löslichen oder zumindest quellbaren Bindemittel und einer unter Einwirkung von aktinischer Strahlung eine starke Säure bildenden Komponente als wesentlichen Bestandteil eine durch Säure spaltbare Verbindung, z. B. mit C-O-C- oder C-O-Si-Bindungen, aufweisen, sind prinzipiell bekannt, beispielsweise aus der DE-A 23 06 248 (= US-A 3,779,778).

Als Verbindungen, die bei Bestrahlung eine starke Säure bilden, wurden bisher insbesondere Onium-Salze, wie Diazonium-, Phosphonium-, Sulfonium- und Jodonium-Salze von nicht nucleophilen Säuren, wie HSbF₆, HAsF₆, oder HPF₆ [J.V. Crivello, Polym. Eng. Sci., 23 (1983) 953], verwendet. Daneben sind Halogenverbindungen, insbesondere Trichlormethyltriazin-Derivate oder Trichlormethyloxadiazol-Derivate, o-Chinondiazidsulfochloride, o-Chinondiazid-4-sulfonsäureester, Organometall-Organohalogen-Kombinationen, Bis(sulfonyl)diazomethane, Sulfonyl-carbonyl-diazomethane (DE-A 39 30 087) oder Nitrobenzyltosylate [F.M. Houlihan et al., SPIE Proc., Adv. in Resist Techn. and Proc. 920 (1988) 67] empfohlen worden.

Diese Verbindungen werden in negativ oder positiv arbeitenden strahlungsempfindlichen Gemischen verwendet. Die Verwendung derartiger photolytischer Säurebildner bringt aber gewisse Nachteile mit sich, die ihre Einsatzmöglichkeiten in verschiedenen Anwendungsbereichen drastisch einschränken. So sind z.B. viele der Oniumsalze toxisch. Ihre Löslichkeit ist in vielen Lösemitteln unzureichend, weshalb nur wenige Lösemittel zur Herstellung einer Beschichtungslösung geeignet sind. Darüber hinaus werden bei Verwendung der Oniumsalze z.T. unerwünschte Fremdatome eingeführt, die insbesondere in der Mikrolithographie zu Prozeßstörungen führen können. Halogenverbindungen, wie z. B. Chinondiazidsulfonsäurechloride, bilden starke Halogenwasserstoffsäuren, besitzen jedoch auf bestimmten Substraten nur eine begrenzte Haltbarkeit, die dadurch verbessert wurde, daß zwischen Substrat und strahlungsempfindlicher Schicht, die Verbindungen des Typs a) enthält, eine Zwischenschicht eingefügt wurde, was allerdings zu einer unerwünschten Zunahme von Defekten und zu einer verminderten Reproduzierbarkeit führte (DE-A 36 21 376 = US-A 4,840,867).

Andere Halogenwasserstoffsäure generierende Verbindungsklassen, wie z. B. Bis- (EP-A 0 137 452 = US-A 4,619,998/4,696,888) oder Tris(trichlormethyl)triazine, weisen zwar eine gute Säurebildungseffizienz auf, besitzen jedoch eine oft unzureichende Löslichkeit in gängigen Resistlösemitteln und werden häufig unter den in der Praxis angewandten Verarbeitungsbedingungen aus den lichtempfindlichen Mischungen ausgeschwitzt, so daß eine reproduzierbare Herstellung der resultierenden Schicht nicht mehr möglich ist.

In neueren Arbeiten von F.M. Houlihan et al., SPIE 920, 67 (1988) wurden anhand positiv arbeitender Systeme gezeigt, daß neben den oben genannten Säurebildnern auch Nitrobenzyltosylate, die bei Belichtung Sulfonsäuren mit geringer Wanderungstendenz bilden, in bestimmten säurelabilen Resistformulierungen verwendbar sind. Es kann aus diesen Ergebnissen abgeleitet werden, daß solche Verbindungen auch für photohärtbare Systeme verwendet werden können. Die dabei erzielten Empfindlichkeiten und die thermische Stabilität der Photoresists erwiesen sich jedoch als unzureichend.

Bereits bekannt sind auch Resistformulierungen mit Naphthochinon-2-diazid-4-sulfonsäureestern, Oximsulfonaten, 1,2-Disulfonen, Bis-sulfonyl-diazomethan (DE-A 39 30 086) und Sulfonyl-carbonyl-diazomethan (DE-A 39 30 087). All diesen Verbindungen gemeinsam sind die unbefriedigenden Quantenausbeuten unter der Einwirkung aktinischer Strahlung. Die Resistformulierungen absorbieren Strahlung der Wellenlänge 248 nm in beträchtlichem Maße. Die Empfindlichkeit gegenüber Strahlung dieser Wellenlänge liegt im Bereich von 50 bis 100 mJ/cm². Praxisgerechte Strukturen einer Größenordnung von 0,5 µm und weniger lassen sich mit solchen Resists nicht abbilden.

Trotz der bisher geleisteten intensiven Forschungstätigkeit auf diesem Gebiet ist derzeit kein strahlungsempfindliches Gemisch bekannt, mit dem sich ein positiv arbeitendes strahlungsempfindliches Aufzeichnungsmaterial herstellen läßt, das eine hohe Empfindlichkeit im DUV-Bereich (200 bis 300 nm) sowie eine hohe Auflösung besitzt, bereits bei kurzzeitiger Bestrahlung eine ausreichende Menge einer Säure freisetzt, die stark genug ist, um Verbindungen des Typs b) zu spalten und das zudem noch wäßrig-alkalisch entwickelbar und mit den in der Praxis üblichen Verarbeitungsbedingungen voll kompatibel ist.

Aufgabe der Erfindung war es daher, ein strahlungsempfindliches Gemisch auf der Basis von säurebildenden in Kombination mit säurespaltbaren Verbindungen vorzuschlagen, wobei die photolytisch eine Säure bildende Verbindung möglichst stabil auf allen bekannten Substraten ist und bei Bestrahlung starke Säure mit hoher Effizienz liefert, in den gängigen Resistlösemitteln eine gute Löslichkeit aufweist und nicht aus der lichtempfindlichen Schicht ausgeschwitzt wird.

Die Aufgabe wird gelöst durch ein strahlungsempfindliches Gemisch mit
a) einer Verbindung, die unter Einwirkung von aktinischer Strahlung starke Säure bildet,
b) einer Verbindung mit mindestens einer durch Säure spaltbaren C-O-C- oder C-O-Si-Bindung und
c) einem in Wasser unlöslichen, in wäßrig-alkalischen Lösungen löslichen oder zumindest quellbaren polymeren Bindemittel,
dadurch gekennzeichnet, daß die Verbindung a) ein mit Sulfonsäure(n) der Formel R-SO₃H bzw. R'(-SO₃H)₂ verestertes 2,4-Bis-trichlormethyl-6-(mono- oder dihydroxyphenyl)-[1,3,5]triazin der allgemeinen Formeln I und/oder II ist 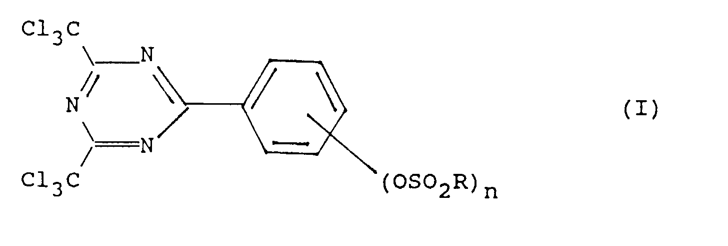 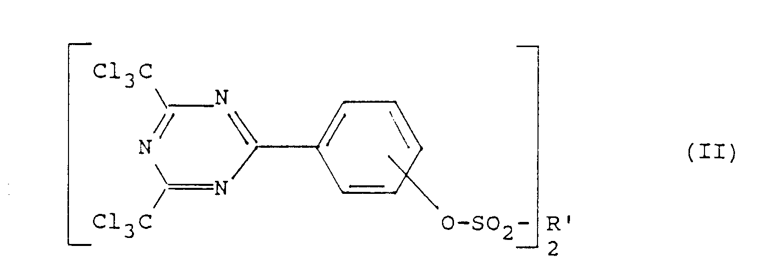 wobei R einen ggf. weiter substituierten (C₁-C₁₀)Alkyl-, (C₅-C₁₀)Cycloalkyl-, (C₆-C₁₀)Aryl-, (C₆-C₁₀)Aryl-(C₁-C₁₀)alkyl-, (C₃-C₉)Heteroarylrest, R' einen ggf. substituierten (C₁-C₁₀)Alkylen-, (C₆-C₁₀)Arylen- oder (C₃-C₉)-Heteroarylenrest bezeichnet und n 1 oder 2 sein kann; wobei die besagten Substituenten (C₁-C₈)-Alkyl, (C₁-C₈)Alkoxy, (C₁-C₈)Alkanoyl, (C₁-C₈)Alkanoyloxy, (C₆-C₁₀)Aryl, Cyano oder Halogen sind.

Im Falle n = 2 können die Reste R auch verschieden sein.

Die Reste R und R' können, wie die folgenden Beispiele zeigen:

Methyl, Ethyl, Propyl, Isopropyl, Butyl, Hexyl, Octyl, Decyl, Dodecyl, Hexadecyl, Octadecyl, 10-Camphyl, Chlormethyl, 2-Chlorethyl, 3-Chlorpropyl, Dichlormethyl, Trichlormethyl, Difluormethyl, Trifluormethyl, 2,2,2-Trifluorethyl, 1,1,2,3,3,3-Hexafluorpropyl, Perfluorhexyl, Phenyl, Benzyl, 4-Acetylphenyl, 2-, 3- oder 4-Bromphenyl, 2-, 3- oder 4-Chlorphenyl, 2-, 3- oder 4-Fluorphenyl, 4-Jodphenyl, 2-, 3- oder 4-Methylphenyl, 4-Ethylyphenyl, 4-Propylphenyl, 4-Isopropylphenyl, 4-Isobutylphenyl, 4-tert.-Butylphenyl, 4-tert.-Amylphenyl, 4-Hexylphenyl, 4-Methoxyphenyl, 4-Butoxyphenyl, 4-Hexadecyloxyphenyl, 2-, 3- oder 4-Trifluormethylphenyl, 2- oder 4-Trifluormethoxyphenyl, 2-, 3- oder 4-Nitrophenyl, 3- oder 4-Carboxyphenyl, 2-Methoxycarbonylphenyl, 4-Tetrafluorethoxyphenyl, β-Styryl, 3,5-Bistrifluormethylphenyl, 2,5-Bis-(2,2,2-trifluorethoxy)phenyl, 2,5-Dimethylphenyl, 2,4-, 2,5- oder 3,4-Dimethoxyphenyl, 2,4-Diisopropylphenyl, 5-Brom-2-methoxyphenyl, 2- oder 3-Chlor-4-fluorphenyl, 3-Chlor-2-methylphenyl, 3-Chlor-4-methoxyphenyl, 2-Chlor-6-methylphenyl, 2-Chlor-4-trifluormethylphenyl, 5-chlor-2-methoxyphenyl, 5-Fluor-2-methylphenyl, 2,5- oder 3,4-Dibromphenyl, 2,3-, 2,4- oder 2,5-, 2,6-, 3,4- oder 3,5-Dichlorphenyl, 2-(2,4-Dichlorphenoxy)phenyl, 2,4- oder 2,5-Difluorphenyl, 3-Carboxy-4-chlorphenyl, 4-Chlor-3- oder 2-Chlor-5-trifluormethylphenyl, 2,4,6-Trimethylphenyl, 2,4,6-Triisopropylphenyl, 2,3,4-, 2,4,5-oder 2,4,6-Trichlorphenyl, 4-Chlor-2,5-dimethylphenyl, 2,4-Dichlor-5-methylphenyl, 4-Brom-2,5-difluorphenyl, 2,3,5,6-Tetramethylphenyl, 4-Methoxy-2,3,6-trimethylphenyl, 2,5-Dibrom-3,6-difluorphenyl, 2,3,4,5,6-Pentafluorphenyl, 1- oder 2-Naphthyl, 8-Chinolinyl, 2-Thienyl, 5-Chlor-2-thienyl, 4-Brom-2,5-dichlor-3-thienyl, 4,5-Dibrom-2-thienyl, 2,3-Dichlor-5-thienyl, 2-Brom-3-Chlor-5-thienyl, 3-Brom-2-chlor-5-thienyl, 3-Brom-5-chlor-2-thienyl, 2,5-Dichlor-3-thienyl, 2-(2-Pyridyl)-5-thienyl, 5-Chlor-1,3-dimethyl-4-pyrazolyl, 3,5-Dimethyl-4-isoxazolyl, 2,4-Dimethyl-5-thiazolyl,
oder
1,4-Butylen, 1,2- oder 1,3-Phenylen, 3-Methyl-1,2-phenylen, 2,4,6-Trimethyl-1,3-phenylen, 4,4'-Biphenylen, 4,4'-Methylendiphenylen, 1,5-Naphthylen, 2-Chlor-3,5-thienylen.

Hinsichtlich der Stellung der Hydroxygruppe(n) am aromatischen Benzolring bestehen keinerlei Einschränkungen, d. h. die entsprechenden Cyanophenol-Vorstufen sind bezüglich des Substitutionsmusters frei wählbar.

Von den Verbindungen der allgemeinen Formel I sind solche mit n = 1 bevorzugt.

In speziellen strahlungsempfindlichen Gemischen können - falls n = 2 ist -, zur Verbesserung der Löslichkeit nicht vollständig veresterte Produkte, d. h. solche, die noch eine freie phenolische Hydroxygruppe aufweisen, bevorzugt eingesetzt werden.

Die Herstellung der in dem erfindungsgemäßen Gemisch eingesetzten, mit Sulfonsäuren der Formel R-SO₃H bzw. R'(-SO₃H)₂ veresterten 2,4-Bis-trichlormethyl-6-(mono- oder dihydroxyphenyl)-[1,3,5]triazine ist an sich bekannt. Als Ausgangsmaterialien dienen dabei in erster Linie Cyanophenole und die entsprechenden Sulfonsäurechloride. Verfahren zu Herstellung von aromatischen Sulfonsäureestern werden beispielsweise von F. Muth in: Houben-Weyl-Müller, Methoden der organischen Chemie, Bd. IX, S. 633 (und dort zitierte Literatur), Thieme-Verlag, 4. Aufl., Stuttgart 1955, und von S. Pawlenko, a.a.O., Bd. E 11, S. 1084, Thieme-Verlag, 1. Aufl., Stuttgart 1985, sowie in der Patentliteratur an zahlreichen Beispielen beschrieben. Auch die entsprechenden Sulfonsäureanhydride sind als Ausgangsmaterialien geeignet (siehe S. Pawlenko, a.a.O., Bd. Ell, S. 1086, Thieme-Verlag, 1. Aufl., Stuttgart 1985, und P. J. Stang, M. Hanack, L. R. Subramaniam, Synthesis, **1982**, 85). Dies gilt insbesondere für die mit Perfluoralkyl-Gruppen substituierten Benzolsulfonsäureanhydride. Die Herstellung der mit den Sulfonsäuren R-SO₃H bzw. R'(-SO₃H)₂ veresterten 2,4-Bis-trichlormethyl-6-(mono- oder dihydroxyphenyl)-[1,3,5]triazine aus den entsprechenden mit den Sulfonsäuren R-SO₃H veresterten Cyanophenolen wurde analog zu dem in der EP-A 0 137 452 offenbarten Verfahren durchgeführt.

Das erfindungsgemäße strahlungsempfindliche Gemisch zeichnet sich durch eine hohe Empfindlichkeit über einen weiten Spektralbereich aus. Während der Verarbeitung unter praxisgerechten Bedingungen wurden keinerlei Einschränkungen bezüglich der Löslichkeit in gängigen Resistlösemitteln und bezüglich des Ausdampfens der strahlungsempfindlichen Komponente a) aus der Schicht beobachtet.

Das strahlungsempfindliche Gemisch zeigt eine hohe thermische Stabilität und schafft die Möglichkeit, auch feinste Strukturen einer Vorlage detailgenau wiederzugeben.

Überraschenderweise ist die Quantenausbeute bei der Bestrahlung des erfindungsgemäßen Gemisches größer als bei der Bestrahlung bekannter 2,4-Bis-trichlormethyl-[1,3,5]-triazine enthaltender Gemische. Diese höhere Effizienz der Säurebildung deutet darauf hin, daß nicht nur Halogenwasserstoffsäuren, sondern auch - jedoch in geringerem Umfang - Sulfonsäuren bei der Bestrahlung bildet werden, was im erfindungsgemäßen Gemisch zu einer gesteigerten Empfindlichkeit führt. Die erfindungsgemäßen positiv arbeitenden, strahlungsempfindlichen Gemische zeigen zudem nicht nur eine hohe thermische und Plasma-Beständigkeit sondern auch hervorragende lithographische Eigenschaften, die eine Auflösung im Halbmikrometer- und teilweise auch im Sub-Halbmikrometer-Bereich erlauben. Man erhält nach dem bildmäßigen Bestrahlen und dem anschließenden Entwickeln ein detailgetreues Abbild der Maske. Die Resistfelder weisen steile Flanken auf. In den bestrahlten Bereichen wird die Resistschicht vollständig abgelöst, d. h. es bleiben keinerlei Reste oder Rückstände der Schicht auf dem Substrat. Das bei der Photolyse gebildete Säuregemisch führt zu einer effizienten Spaltung der Resist-Komponente b), was die Herstellung von hochempfindlichen positiv arbeitenden Gemischen erlaubt.

Mit den erfindungsgemäßen Gemischen hergestellte Aufzeichnungsmaterialien zeigen überraschend eine höchsten Ansprüchen genügende Bilddifferenzierung und, noch überraschender, eine Verbesserung des Kontrasts und des Auflösungsvermögens. Die erfindungsgemäßen Gemische erlauben beispielsweise die Herstellung eines hochempfindlichen positiv arbeitenden Photoresists für energiereiche UV2-Strahlung (z. B. 248 nm).

Da das erfindungsgemäße Gemisch über einen weiten Spektralbereich empfindlich ist, ist zum bildmäßigen Bestrahlen aktinische Strahlung allgemein geeignet. Als aktinische Strahlung soll in diesem Zusammenhang jede Strahlung verstanden werden, deren Energie mindestens der des kurzwelligen sichtbaren Lichts entspricht. Geeignet ist dabei insbesondere UV-Strahlung im Bereich von 190 bis 450 nm, bevorzugt von 200 bis 400 nm, besonders bevorzugt von 200 bis 300 nm, aber auch Elektronen- oder Röntgenstrahlung. In dem erfindungsgemäßen strahlungsempfindlichen Gemisch kann das bei Bestrahlung Säure bildende und mit Sulfonsäure(n) der Formel R-SO₃H bzw. R'(-SO₃H)₂ veresterte 2,4-Bis-trichlormethyl-6-(mono- oder dihydroxyphenyl)-[1,3,5]triazin allein oder in Kombination mit anderen Säurebildnern Verwendung finden.

Darüber hinaus lassen sich die Verbindungen des Typs a) auch mit Halogenverbindungen, insbesondere mit bereits bekannten Trichlormethyltriazinderivaten oder Trichlormethyloxadiazolderivaten, Onium-Salzen, 1,2-Disulfonen, o-Chinondiazidsulfonylchloriden oder Organometall-Organo-halogen-Kombinationen kombinieren. Es kommen aber auch Mischungen mit Bis(sulfonyl)diazomethanen und Sulfonylcarbonyldiazomethanen in Frage. In solchen Gemischen können jedoch die eingangs erwähnten Nachteile wieder auftreten.

Der Anteil an mit Sulfonsäure(n) der Formel R-SO₃H bzw. R'(-SO₃H)₂ verestertem 2,4-Bis-trichlormethyl-6-(mono- oder dihydroxyphenyl)-[1,3,5]triazin im erfindungsgemäßen Gemisch liegt im allgemeinen bei 0,25 bis 15 Gew.-%, bevorzugt bei 0,5 bis 5 Gew.-%, bezogen auf das Gesamtgewicht der Feststoffe im Gemisch.

Als säurespaltbare Verbindungen in dem erfindungsgemäßen strahlungsempfindlichen Gemisch haben sich vor allem folgende Verbindungsklassen bewährt:
(a) solche mit mindestens einer Orthocarbonsäureester- und bzw. oder Carbonsäureamidacetalgruppe, wobei die Verbindungen auch polymeren Charakter haben und die genannten Gruppen in der Hauptkette oder seitenständig auftreten können,
(b) oligomere oder polymere Verbindungen mit wiederkehrenden Acetal- und/oder Ketalgruppen in der Hauptkette,
(c) Verbindungen mit mindestens einer Enolether- oder N-Acyliminocarbonatgruppe,
(d) cyclische Acetale oder Ketale von β-Ketoestern oder -amiden,
(e) Verbindungen mit Silylethergruppen,
(f) Verbindungen mit Silylenolethergruppen,
(g) Monoacetale bzw. Monoketale von Aldehyden bzw. Ketonen, deren Löslichkeit im Entwickler zwischen 0,1 und 100 g/l beträgt,
(h) Ether auf der Basis tertiärer Alkohole,
(i) Carbonsäureester und Carbonate, deren Alkoholkomponente ein tertiärer Alkohol, ein Allylalkohol oder ein Benzylalkohol ist, und
(j) N,O-Acetale, insbesondere N,O-Polyacetale.

Durch Säure spaltbare Verbindungen wurden bereits weiter oben kurz beschrieben. So findet man säurespaltbare Verbindungen des Typs (a) als Komponenten strahlungsempfindlicher Gemische in den DE-A 26 10 842 und 29 28 636 ausführlich beschrieben. Gemische, die Verbindungen des Typs (b) enthalten, sind in den DE-A 23 06 248 und 27 18 254 dargestellt. Verbindungen des Typs (c) werden in den EP-A 0 006 626 und 0 006 627 beschrieben. Verbindungen des Typs (d) werden in der EP-A 0 202 196 und Verbindungen, die dem Typ (e) zuzurechnen sind, in den DE-A 35 44 165 und 36 01 264 vorgestellt. Verbindungen des Typs (f) findet man in den DE-A 37 30 785 und 37 30 783, während Verbindungen vom Typ (g) in der DE-A 37 30 787 behandelt werden. Verbindungen vom Typ (h) werden z. B. in der US-A 4,603,101 beschrieben und Verbindungen vom Typ (i) z. B. in der US-A 4,491,628 sowie von J. M. Fréchet et al., J. Imaging Sci. 30, 59-64 (1986). Verbindungen des Typs (j) werden in der nicht vorveröffentlichten deutschen Patentanmeldung P 41 12 968.7 offenbart.

Es können auch Mischungen der vorgenannten säurespaltbaren Materialien eingesetzt werden. Bevorzugt ist allerdings ein säurespaltbares Material, das nur einem der obengenannten Typen zugeordnet werden kann, besonders ein solches mit mindestens einer durch Säure spaltbaren C-O-C-Bindung, d. h. besonders bevorzugt sind diejenigen Materialien, die den Typen (a), (b), (g), (i) und (j) angehören. Unter Typ (b) sind besonders die polymeren Acetale hervorzuheben; von den säurespaltbaren Materialien des Typs (g) insbesondere diejenigen, die sich von Aldehyden bzw. Ketonen mit einem Siedepunkt über 150 °C, vorzugsweise über 200 °C, ableiten. Besonders bevorzugt sind die N,O-Polyacetale des Typs (j).

Die Verbindung b) bzw. die Kombination von Verbindungen b) hat einen Anteil von 1 bis 50 Gew.-%, bevorzugt 10 bis 40 Gew.-%, am Gesamtgewicht der Feststoffe des strahlungsempfindlichen Gemisches.

Das erfindungsgemäße strahlungsempfindliche Gemisch enthält ferner mindestens ein polymeres, in Wasser unlösliches, in wäßrig-alkalischen Lösungen dagegen lösliches, zumindest quellbares Bindemittel c). Das Bindemittel zeichnet sich im besonderen dadurch aus, daß es mit den übrigen Bestandteilen des erfindungsgemäßen strahlungsempfindlichen Gemisches gut verträglich ist und insbesondere im Wellenlängenbereich von 190 bis 300 nm eine möglichst geringe Eigenabsorption, d.h. eine hohe Transparenz, aufweist. Bindemittel auf der Basis von Novolak-Kondensationsharzen, die in der Regel in Kombination mit Naphthochinondiaziden als photoaktive Komponenten eingesetzt werden, erfüllen diese Bedingung nicht. Zwar lassen Novolak-Kondensationsharze nach bildmäßiger Belichtung in den nicht belichteten Bereichen eine Verringerung der Löslichkeit gegenüber wäßrig-alkalischen Entwicklern erkennen, doch ist ihre Eigenabsorption im Bereich der für die Bestrahlung gewünschten kurzen Wellenlänge unerwünscht hoch.

Novolak-Kondensationsharze können aber in Mischung mit anderen als Bindemittel geeigneten Harzen mit höherer Transparenz eingesetzt werden. Die Mischungsverhältnisse richten sich dabei vorwiegend nach der Art des mit dem Novolakharz zu mischenden Bindemittels. Insbesondere spielen dessen Grad an Eigenabsorption im genannten Wellenlängenbereich, aber auch die Mischbarkeit mit den anderen Bestandteilen des strahlungsempfindlichen Gemisches eine entscheidende Rolle. Im allgemeinen kann aber das Bindemittel des erfindungsgemäßen strahlungsempfindlichen Gemisches bis zu 30 Gew.-%, insbesondere bis zu 20 Gew.-%, eines Novolak-Kondensationsharzes enthalten.

Als Bindemittel geeignet sind Homo- oder Copolymere des 4-Hydroxystyrols sowie seiner Alkylderivate, z. B. des 3-Methyl-4-hydroxystyrols, Homo- oder Copolymere anderer Vinylphenole, z. B. des 3-Hydroxystyrols, und der Ester oder Amide von Acrylsäure mit phenolischen Gruppen aufweisenden Aromaten. Als Comonomere können polymerisierbare Verbindungen wie Styrol, Methyl(meth)acrylat oder ähnliche eingesetzt werden.

Gemische mit erhöhter Plasmabeständigkeit werden erhalten, wenn zur Herstellung der Bindemittel Silicium enthaltende Vinylmonomere, z. B. Vinyltrimethylsilan, mitverwendet werden. Die Transparenz dieser Bindemittel ist im Deep-UV-Bereich im allgemeinen höher, so daß eine verbesserte Strukturierung möglich ist.

Mit gleichem Erfolg lassen sich Homo- oder Copolymere des Maleimids verwenden. Diese Bindemittel zeigen ebenfalls eine hohe Transparenz im Deep-UV-Bereich. Als Comonomere werden auch hier bevorzugt Styrol, substituierte Styrole, Vinylether, Vinylester, Vinylsilylverbindungen oder (Meth)acrylsäureester eingesetzt.

Schließlich sind darüber hinaus auch Copolymere des Styrols mit Comonomeren verwendbar, die in wäprig alkalischen Lösungen eine Löslichkeitserhöhung bewirken. Hierzu zählen beispielsweise Maleinsäureanhydrid und Maleinsäurehalbester.

Die genannten Bindemittel können auch untereinander gemischt werden, sofern sich dadurch die optische Qualität des strahlungsempfindlichen Gemisches nicht verschlechtert. Bindemittelgemische sind jedoch nicht bevorzugt.

Die Menge des Bindemittels beträgt im allgemeinen 40 bis 95 Gew.-%, insbesondere 50 bis 90 Gew.-%, bezogen auf das Gesamtgewicht der festen Anteile des strahlungsempfindlichen Gemisches.

Die Extinktion des Bindemittels bzw. der Kombination von Bindemitteln für Strahlung der Wellenlänge 248 nm beträgt bevorzugt weniger als 0,35, besonders bevorzugt weniger als 0,25 µm⁻¹.

Die Glasübergangstemperatur des Bindemittels bzw. des Bindemittelgemisches liegt vorteilhaft bei mindestens 120 °C.

Ferner können den erfindungsgemäßen strahlungsempfindlichen Gemischen gegebenenfalls Farbstoffe, Pigmente, Weichmacher, Netzmittel und Verlaufmittel, aber auch Polyglykole, Celluloseether, z. B. Ethylcellulose, zur Erfüllung spezieller Erfordernisse, wie Flexibilität, Haftung und Glanz, zugesetzt werden.

Soll ein Substrat beschichtet werden, so wird das erfindungsgemäße strahlungsempfindliche Gemisch zweckmäßig in einem Lösemittel oder in einer Kombination von Lösemitteln gelöst. Letztendlich hängt die Wahl des Lösemittels bzw. Lösemittelgemisches ab von dem angewandten Beschichtungsverfahren, der gewünschten Schichtstärke und den Trocknungsbedingungen. Ebenso müssen die Lösemittel unter den angewendeten Bedingungen gegenüber den übrigen Schichtbestandteilen chemisch inert sein. Besonders geeignete Lösemittel sowie Beschichtungsverfahren sind in der nicht vorveröffentlichten deutschen Patentanmeldung P 41 12 971.7 ausführlich beschrieben und werden hier analog eingesetzt.

Die mit den genannten Lösemitteln hergestellte Lösung hat in der Regel einen Feststoffgehalt von 5 bis 60 Gew.-%, vorzugsweise bis 50 Gew.-%.

Gegenstand der Erfindung ist schließlich auch ein strahlungsempfindliches Aufzeichnungsmaterial, das im wesentlichen aus einem Substrat und einer darauf befindlichen strahlungsempfindlichen Schicht aus dem erfindungsgemäßen strahlungsempfindlichen Gemisch besteht. Als Substrate kommen alle Materialien in Frage, aus denen Kondensatoren, Halbleiter, mehrlagige gedruckte Schaltungen oder integrierte Schaltkreise bestehen bzw. hergestellt werden können. Gegebenenfalls wird ein Haftvermittler eingesetzt. Die aus der nicht vorveröffentlichten deutschen Patentanmeldung P 41 12 971.7 bekannten Substrate, Haftvermittler und Trägermaterialien zur Herstellung photomechanischer Aufzeichnungsschichten werden auch hier analog angewendet.

Das erfindungsgemäße Aufzeichnungsmaterial wird mit aktinischer Strahlung bildmäßig belichtet. Geeignete Strahlungsquellen werden ebenfalls in der vorgenannten Patentanmeldung ausführlich beschrieben und hier entsprechend eingesetzt.

Die Stärke der lichtempfindlichen Schicht hängt vom Verwendungszweck ab. Sie beträgt im allgemeinen zwischen 0,1 und 100 µm, bevorzugt zwischen 0,5 und 10 µm, besonders bevorzugt um 1,0 µm.

Gegenstand der Erfindung ist ferner ein Verfahren zur Herstellung eines strahlungsempfindlichen Aufzeichnungsmaterials. Für das Auftragen des strahlungsempfindlichen Gemisches auf das Substrat gelten die in der P 41 12 971.7 gemachten Ausführungen ebenso wie für die als Entwickler geeigneten wäßrigen Lösungen, das Nachhärten von entwickelten Schichtstrukturen und die Verwendung des erfindungsgemäßen strahlungsempfindlichen Gemischs bei der Herstellung von integrierten Schaltungen oder von einzelnen elektrischen Bausteinen mit lithographischen Prozessen.

Die erfindungsgemäßen strahlungsempfindlichen Gemische weisen besonders bei Bestrahlung mit Licht einer Wellenlänge zwischen 190 bis 300 nm eine hohe Lichtempfindlichkeit auf. Da die Gemische bei Belichtung sehr gut ausbleichen, lassen sich feinere Strukturen erzielen als dies mit bekannten Gemischen möglich ist. Die entwickelte Resistschicht dient dabei als Maske für die folgenden Prozeßschritte. Solche Schritte sind z. B. das Ätzen des Schichtträgers, das Implantieren von Ionen in den Schichtträger oder das Abscheiden von Metallen oder anderen Materialien auf dem Schichtträger.

Die nachstehend beschriebenen Beispiele illustrieren die Erfindung, sollen aber keine Einschränkung bewirken. Gt steht im Folgenden für Gewichtsteile, Vt für Volumenteile. Gt verhalten sich zu Vt wie g zu cm³.

### Herstellungsbeispiel 1:

1. Stufe: 25,0 Gt 4-Cyanophenol und 31,2 Gt Triethylamin werden in 200 Gt Tetrahydrofuran gelöst und auf 5°C gekühlt. Unter Rühren und Konstanthalten der Temperatur werden 39,8 Gt p-Toluolsulfonsäurechlorid, gelöst in 50 Gt Tetrahydrofuran, zugetropft. Die Mischung wird auf Raumtemperatur gebracht, 2 Stunden nachgerührt und in 1000 Vt destilliertes Wasser eingerührt. Nach dem Ansäuern auf pH 2 bis 3 wird der Niederschlag abgesaugt, mit Wasser neutral gewaschen und getrocknet. Das kristalline Material wird aus Isopropanol umkristallisiert. Man erhält 53 Gt 4-(Toluol-4-sulfonyloxy)-benzonitril (weiße Kristalle mit einem Schmelzpunkt von 85°C).
2. Stufe: 13,6 Gt der vorstehend beschriebenen Verbindung werden unter Feuchtigkeitsausschluß in 43,4 Gt Trichloracetonitril gelöst und mit 2,7 Gt Aluminiumbromid versetzt. In diese Mischung wird bei 24 bis 30°C trockenes Chlorwasserstoffgas bis zur Sättigung eingeleitet. Die sich verfestigende Mischung läßt man 24 Stunden bei Raumtemperatur stehen. Sie wird dann in 400 Gt Methylenchlorid aufgenommen und zweimal mit je 100 Gt Wasser gewaschen. Die organische Phase wird getrocknet, filtriert und eingeengt. Der Rückstand wird aus Ethanol umkristallisiert. Man erhält 23,5 Gt 2,4-Bis-trichlormethyl-6-[4-(toluol-4-sulfonyloxy)-phenyl]-[1,3,5]triazin (weiße Kristalle mit einem Schmelzpunkt von 156°C).

### Herstellungsbeispiel 2:

1. Stufe: 25,0 Gt 4-Cyanophenol und 31,2 Gt Triethylamin werden in 200 Gt Tetrahydrofuran gelöst und auf 5°C gekühlt. Unter Rühren und Konstanthalten der Temperatur werden 23,3 Gt Methansulfonsäurechlorid, gelöst in 50 Gt Tetrahydrofuran, zugetropft. Die Mischung wird auf Raumtemperatur gebracht, 2 Stunden nachgerührt und in 1000 Vt destilliertes Wasser eingerührt. Nach dem Ansäuern auf pH 2 bis 3 wird der Niederschlag abgesaugt, mit Wasser neutral gewaschen und getrocknet. Das kristalline Material wird aus Isopropanol umkristallisiert. Man erhält 35 Gt 4-Methansulfonyloxy-benzonitril (weiße Kristalle mit einem Schmelzpunkt von 93°C).
2. Stufe: 9,8 Gt der vorstehend beschriebenen Verbindung werden unter Feuchtigkeitsausschluß in 43,4 Gt Trichloracetonitril gelöst und mit 2,7 Gt Aluminiumbromid versetzt. In diese Mischung wird bei 24 bis 30°C trockenes Chlorwasserstoffgas bis zur Sättigung eingeleitet. Die sich verfestigende Mischung wird 24 Stunden bei Raumtemperatur stehengelassen. Sie wird in 400 Gt Methylenchlorid aufgenommen und zweimal mit je 100 Gt Wasser gewaschen. Die organische Phase wird getrocknet, filtriert und eingeengt. Der Rückstand wird aus Ethanol umkristallisiert. Man erhält 13,8 Gt 2,4-Bis-trichlormethyl-6-(4-methansulfonyloxy-phenyl)-[1,3,5]triazin (weiße Kristalle mit einem Schmelzpunkt von 142°C).

### Herstellungsbeispiel 3:

1. Stufe: 11,9 Gt 4-Cyanophenol und 15,0 Gt Triethylamin werden in 120 Gt Tetrahydrofuran gelöst und auf 0°C gekühlt. Dazu werden unter Rühren und Konstanthalten der Temperatur 22,6 Gt Naphthalin-2-sulfonylchlorid, gelöst in 50 Gt Tetrahydrofuran getropft. Die Mischung wird auf Raumtemperatur gebracht, 2 Stunden nachgerührt und in 1000 Vt destilliertes Wasser eingerührt. Nach dem Ansäuern auf pH 2 bis 3 wird der Niederschlag abgesaugt, mit Wasser neutral gewaschen und getrocknet. Das kristalline Material wird aus Isopropanol umkristallisiert. Man erhält 25,3 Gt 4-(Naphthalin-2-sulfonyloxy)-benzonitril (weiße Kristalle mit einem Schmelzpunkt von 112°C).
2. Stufe: 23,2 Gt der vorstehend beschriebenen Verbindung werden unter Feuchtigkeitsausschluß in 65,0 Gt Trichloracetonitril gelöst und mit 4,0 Gt Aluminiumbromid versetzt. In diese Mischung wird bei 24 bis 30°C trockenes Chlorwasserstoffgas bis zur Sättigung eingeleitet. Die sich verfestigende Mischung läßt man 24 Stunden bei
   Raumtemperatur stehen. Sie wird dann in 400 Gt Methylenchlorid aufgenommen und zweimal mit je 100 Gt Wasser gewaschen. Die organische Phase wird getrocknet, filtriert und eingeengt. Der Rückstand wird aus Ethylacetat umkristallisiert. Man erhält 32,5 Gt 2,4-Bis-trichlormethyl-6-[4-(naphthalin-2-sulfonyloxy)-phenyl]-[1,3,5]triazin (weiße Kristalle mit einem Schmelzpunkt von 175°C).

### Herstellungsbeispiel 4:

1. Stufe: 6,0 Gt 4-Cyanophenol und 7,5 Gt Triethylamin werden in 200 Gt Tetrahydrofuran gelöst und auf 5°C gekühlt. Dazu werden unter Rühren und Konstanthalten der Temperatur 10,3 Gt 4-Methoxybenzolsulfonylchlorid, gelöst in 50 Gt Tetrahydrofuran, getropft. Die Mischung wird auf Raumtemperatur gebracht, 2 Stunden nachgerührt und in 1000 Vt destilliertes Wasser eingerührt. Nach dem Ansäuern auf pH 2 bis 3 wird der Niederschlag abgesaugt, mit Wasser neutral gewaschen und getrocknet. Das kristalline Material wird aus Isopropanol umkristallisiert. Man erhält 13 Gt 4-(4-Methoxy-benzolsulfonyloxy)-benzonitril (weipe Kristalle mit einem Schmelzpunkt von 128°C).
2. Stufe: 11,6 Gt der vorstehend beschriebenen Verbindung werden unter Feuchtigkeitsausschluß in 35,0 Gt Trichloracetonitril gelöst und mit 2,5 Gt Aluminiumbromid versetzt. In diese Mischung wird bei 24 bis 30°C trockenes Chlorwasserstoffgas bis zur Sättigung eingeleitet. Die sich verfestigende Mischung läßt man 24 Stunden bei Raumtemperatur stehen. Sie wird in 300 Gt Methylenchlorid aufgenommen und zweimal mit je 100 Gt Wasser gewaschen. Die organische Phase wird getrocknet, filtriert und eingeengt. Der Rückstand wird aus Ethylacetat umkristallisiert. Man erhält 16,8 Gt 2,4-Bis-trichlormethyl-6-[4-(4-methoxybenzolsulfonyloxy)-phenyl]-[1,3,5]triazin (weiße Kristalle mit einem Schmelzpunkt von 168°C).

### Herstellungsbeispiel 5:

1. Stufe: 4,0 Gt 3-Cyanophenol und 5,1 Gt Triethylamin werden in 100 Gt Tetrahydrofuran gelöst und auf 5°C gekühlt. Dazu werden unter Rühren und Konstanthalten der Temperatur 10,0 Gt 2,4,6-Triisopropylbenzolsulfonylchlorid, gelöst in 50 Gt Tetrahydrofuran, getropft. Die Mischung wird auf Raumtemperatur gebracht, 2 Stunden nachgerührt und in 1000 Vt destilliertes Wasser eingerührt. Nach dem Ansäuern auf pH 2 bis 3 wird der Niederschlag abgesaugt, mit Wasser neutral gewaschen und getrocknet. Das kristalline Material wird aus Isopropanol umkristallisiert. Man erhält 12 Gt 3-(2,4,6-Triisopropylbenzolsulfonyloxy)-benzonitril (weiße Kristalle mit einem Schmelzpunkt von 70°C).
2. Stufe: 11,5 Gt der vorstehend beschriebenen Verbindung werden unter Feuchtigkeitsausschluß in 26,0 Gt Trichloracetonitril gelöst und mit 2,0 Gt Aluminiumbromid versetzt. In diese Mischung wird bei 24 bis 30°C trockenes Chlorwasserstoffgas bis zur Sättigung eingeleitet. Die sich verfestigende Mischung läßt man 24 Stunden bei Raumtemperatur stehen. Sie wird in 200 Gt Methylenchlorid aufgenommen und zweimal mit je 100 Gt Wasser gewaschen. Die organische Phase wird getrocknet, filtriert und eingeengt. Der Rückstand wird aus Ethylacetat umkristallisiert. Man erhält 10,5 Gt 2,4-Bis-trichlormethyl-6-[3-(2,4,6-triisopropyl-benzolsulfonyloxy)-phenyl]-[1,3,5]triazin (weiße Kristalle mit einem Schmelzpunkt von 156°C).

### Herstellungsbeispiel 6:

1. Stufe: 11,9 Gt 2-Cyanophenol und 15,2 Gt Triethylamin werden in 100 Gt Tetrahydrofuran gelöst und auf 5°C gekühlt. Dazu werden unter Rühren und Konstanthalten der Temperatur 11,4 Gt Methansulfonsäurechlorid, gelöst in 50 Gt Tetrahydrofuran, getropft. Die Mischung wird auf Raumtemperatur gebracht, 2 Stunden nachgerührt und in 1000 Vt destilliertes Wasser eingerührt. Nach dem Ansäuern auf pH 2 bis 3 wird der Niederschlag abgesaugt, mit Wasser neutral gewaschen und getrocknet. Das kristalline Material wird aus Isopropanol umkristallisiert. Man erhält 13,5 Gt 2-Methansulfonyloxy-benzonitril (weiße Kristalle mit einem Schmelzpunkt von 58°C).
2. Stufe: 12,8 Gt der vorstehend beschriebenen Verbindung werden unter Feuchtigkeitsausschluß in 56,6 Gt Trichloracetonitril gelöst und mit 2,0 Gt Aluminiumbromid versetzt. In diese Mischung wird bei 24 bis 30°C trockenes Chlorwasserstoffgas bis zur Sättigung eingeleitet. Die sich verfestigende Mischung läßt man 24 Stunden bei Raumtemperatur stehen. Sie wird in 200 Gt Methylenchlorid aufgenommen und zweimal mit je 100 Gt Wasser gewaschen. Die organische Phase wird getrocknet, filtriert und eingeengt. Der Rückstand wird aus Isopropanol umkristallisiert. Man erhält 15,7 Gt 2,4-Bis-trichlormethyl-6-(2-methansulfonyloxy-phenyl)-[1,3,5]triazin (weiße Kristalle mit einem Schmelzpunkt von 86°C).

### Herstellungsbeispiele 7 bis 13

Es werden weitere Verbindungen der allgemeinen Formel I vorgestellt, die analog zu den bisher beschriebenen Beispielen hergestellt wurden. Wegen der Vielzahl der Verbindungen werden einige ausgewählte Vertreter in der folgenden Tabelle hinsichtlich der in der allgemeinen Formel I beschriebenen Variationsmöglichkeiten charakterisiert. Als Analysenwert ist die quantitative Bestimmung des Schwefel- und des Chlorgehalts hinreichend aussagefähig.

**Tabelle**

| Nr. | Position *) | R | Schmp. [^{o}C] | Elementaranalyse | | | |
|---|---|---|---|---|---|---|---|
| | | | | % Cl | | % S | |
| | | | | ber. | gef. | ber. | gef. |
| 7 | para | -C₆H₅ | 140 | 38,8 | 38,2 | 5,8 | 5,3 |
| 8 | para | -2,4,5-(Cl)₃-C₆H₂ | 190 | 49,0 | 49,0 | 4,9 | 5,2 |
| 9 | para | -4-Cl-C₆H₄ | 150 | 42,6 | 43,1 | 5,5 | 5,4 |
| 10 | para | -4-Br-C₆H₄ | 148 | 33,9 | 34,2 | 5,1 | 5,2 |
| 11 | meta | -4-CH₃-C₆H₄ | 162 | 37,8 | 38,1 | 5,7 | 6,0 |
| 12 | meta | -CH₃ | 120 | 43,8 | 48,5 | 6,6 | 5,9 |
| 13 | ortho | -4-CH₃-C₆H₄ | 86 | 37,8 | 39,4 | 5,7 | 6,1 |

| | | | | | | | |
|---|---|---|---|---|---|---|---|
| *) Bezogen auf die Stellung der 2,4-Bis-trichlormethan-[1,3,5]triazin-6-yl-Gruppe am Benzolring. | | | | | | | |

Auf analoge Weise lassen sich auch andere der weiter oben beschriebenen, mit Sulfonsäuren der Formel R-SO₃H bzw. R'(-SO₃H)₂ veresterten, 2,4-Bis-trichlormethyl-6-(mono- oder dihydroxyphenyl)-[1,3,5]triazine herstellen.

Die Charakterisierung der mit Sulfonsäure(n) der Formel R-SO₃H bzw. R'(-SO₃H)₂ veresterten 2,4-Bis-trichlormethyl-6-(mono- oder dihydroxyphenyl)-[1,3,5]triazine erfolgte durch ¹H-Hochfeld-Kernresonanzspektren sowie durch Elementaranalysen und durch IR-Spektroskopie zum Beweis der Abwesenheit freier Hydroxygruppen im Produkt.

### Anwendungsbeispiele 1 bis 5

Die Beispiele 1 bis 5 belegen die Eignung des erfindungsgemäßen Gemischs für Aufzeichnungsmaterialien in der Mikrolithographie. Anhand der Vergleichsbeispiele 6 und 7 wird die Überlegenheit der erfindungsgemäßen Gemische gegenüber dem Stand der Technik gezeigt.

### Beispiel 1

Es wurde eine Beschichtungslösung hergestellt aus

| | |
|---|---|
| 4,5 Gt | eines Homopolymeren aus 3-Methyl-4-hydroxystyrol mit einem Erweichungsbereich um 150 °C und einem mittleren Molekulargewicht um 28.000 [bestimmt durch Gelpermeationschromatographie (GPC)], |
| 3,0 Gt | eines N,O-Polyacetals, hergestellt aus Benzaldehyd-dimethylacetal und einem Urethanalkohol (hergestellt aus Ethylencarbonat und n-Propylamin) gemäß Herstellungsbeispiel 1 der nicht vorveröffentlichten deutschen Patentanmeldung P 41 12 968.7 und |
| 0,15 Gt | 2,4-Bis-trichlormethyl-6-[4-(toluol-4-sulfonyloxy)-phenyl]-[1,3,5]triazin gemäß dem Herstellungsbeispiel 1, in |
| 42 Gt | Propylenglykol-monomethylether-acetat. |

Die Beschichtungslösung wurde durch einen Filter mit einem Porendurchmesser von 0,2 µm filtriert und auf einen mit einem Haftvermittler (Hexamethyldisilazan) vorbehandelten Wafer aufgeschleudert. Die Schleuderdrehzahl wurde dabei so gewählt, daß nach 1 min Trocknen bei 130 °C auf einer hot plate Schichtdicken um 1,07 µm erhalten wurden.

Das Aufzeichnungsmaterial wurde bildmäßig unter einer Vorlage mit der Strahlung eines KrF-Excimer-Lasers (248 nm) mit einer Energie von 3,8 mJ/cm² belichtet und anschließend bei 50 °C für 1 min einem post exposure bake auf einer hot plate unterzogen.

Entwickelt wurde das Aufzeichnungsmaterial mit einer 0,27 n wäßrigen Tetramethylammoniumhydroxid-Lösung.

Nach einer Entwicklungsdauer von 30 s erhielt man ein fehlerfreies Abbild der Maske mit steilen Resistflanken, wobei auch Strukturen von 0,35 µm detailgetreu aufgelöst waren. Eine Untersuchung der Flanken der Resistprofile mit Rasterelektronenmikroskopie belegte, dap diese praktisch senkrecht zur Substratoberfläche ausgerichtet waren.

Die in den Beispielen 2 bis 5 beschriebenen, strahlungsempfindlichen Aufzeichnungsmaterialien ergaben ebenfalls ein fehlerfreies Abbild der Maske mit steilen Resistflanken, wobei auch Strukturen < 0,40 µm detailgetreu aufgelöst waren. Die Resistflanken waren in allen Fällen nahezu senkrecht zur Substratoberfläche ausgerichtet.

### Beispiel 2:

Es wurde eine Beschichtungslösung hergestellt aus

| | |
|---|---|
| 4,5 Gt | eines Copolymeren aus Styrol/p-Hydroxystyrol (Molverhältnis 75:25) mit einem mittleren Molekulargewicht von 30.000 (GPC), |
| 3,0 Gt | eines O,O-Acetals, hergestellt aus Terephthaldialdehyd-tetramethylacetal und 2-Phenoxyethanol, hergestellt analog dem Herstellungsbeispiel 1 der DE-A 37 30 787 und |
| 0,1 Gt | 2,4-Bis-trichlormethyl-6-(4-benzolsulfonyloxy-phenyl)-[1,3,5]triazin gemäß dem Herstellungsbeispiel 7, in |
| 42 Gt | Propylenglykol-monomethylether-acetat. |

Beschichtungs-, Trocknungs- und Entwicklungsbedingungen entsprachen Beispiel 1 (post exposure bake: 75 °C/45 s).

Das Aufzeichnungsmaterial wurde bildmäßig unter einer Vorlage mit der UV-Strahlung einer Xenon-Quecksilberdampflampe bei 260 nm (mit einem Interferenzfilter) mit einer Energie von 4,6 mJ/cm² belichtet und 50 s entwickelt.

### Beispiel 3

Es wurde ein Wafer hergestellt mit einer Beschichtungslösung wie in Beispiel 1, mit der einzigen Abweichung, daß anstelle der dort eingesetzten 0,15 Gt 2,4-Bis-trichlormethyl-6-(4-toluol-4-sulfonyloxy)-phenyl-[1,3,5]triazin nunmehr 0,075 Gt 2,4-Bis-trichlormethyl-6-[4-(4-methoxy-benzolsulfonyloxy)-phenyl]-[1,3,5]triazin, hergestellt gemäß dem Herstellungsbeispiel 4, verwendet wurden. Der Wafer wurde dann bildmäßig mit einer Energie von 5,7 mJ/cm² belichtet (KrF-Excimer-Laser). Nach einem post exposure bake (60 °C/1 min) wurde wie in Beispiel 1 beschrieben entwickelt, wobei die belichteten Bereiche innerhalb von 40 s rückstandsfrei abgelöst wurden.

### Beispiel 4

Es wurde eine Beschichtungslösung hergestellt aus

| | |
|---|---|
| 7,0 Gt | eines Copolymeren aus 3-Methyl-4-hydroxystyrol/4-Hydroxystyrol (Molverhältnis 72:28) mit einem Erweichungsbereich um 155 ^{o}C und einem mittleren Molekulargewicht von 26.000 (GPC), |
| 3,0 Gt | eines N,O-Polyacetals, hergestellt aus 3,4-Methylendioxy-benzaldehyd-dimethylacetal und einem Urethanalkohol (hergestellt aus Ethylen-oxid und n-Hexylamin), gemäß Herstellungsbeispiel 2 der nicht vorveröffentlichten deutschen Patentanmeldung P 41 12 968.7 und |
| 0,25 Gt | 2,4-Bis-trichlormethyl-6-(4-methansulfonyloxy-phenyl)-[1,3,5]triazin, hergestellt gemäß dem Herstellungsbeispiel 2, in |
| 42 Gt | Propylenglykol-monomethylether-acetat. |

Die Lösung wurde wie in Beispiel 1 vorbehandelt, aufgeschleudert, getrocknet (120 °C/1 min) und das Aufzeichnungsmaterial bildmäßig mit einer Energie von 3,4 mJ/cm² belichtet (Xenon-Quecksilberdampflampe). Nach dem post exposure bake (60 °C/1 min) wurde wie in Beispiel 1 entwickelt, wobei die belichteten Bereiche innerhalb von 50 s rückstandsfrei abgelöst wurden.

### Beispiel 5

Wie in Beispiel 1 beschrieben, wurde ein Wafer hergestellt mit einer Beschichtungslösung wie in Beispiel 4, mit der einzigen Abweichung, daß anstelle der dort eingesetzten 3,0 Gt eines N,O-Polyacetals 2,0 Gt eines O,O-Acetals, hergestellt aus Benzaldehyd-dimethylacetal und 3-Phenylpropanol analog dem Herstellungsbeispiel 1 der DE-A 37 30 787, verwendet wurden. Der Wafer wurde dann bildmäßig mit einer Energie von 4,3 mJ/cm² belichtet (Xenon-Quecksilberdampflampe). Nach einem post exposure bake (70 °C/1 min) wurde wie in Beispiel 1 beschrieben entwickelt, wobei die belichteten Bereiche innerhalb von 70 s rückstandsfrei abgelöst wurden.

### Beispiele 6 und 7 (Vergleichsbeispiele)

Die Resistformulierung des Beispiels 4 wurde derart abgeändert, daß die dort verwendete säurebildende Verbindung durch die gleiche Menge an 2,4-Bis-trichlormethyl-6-(4-methoxy-naphthalin-1-yl)-[1,3,5]triazin (Photoinitiator Nr. 3 in Tabelle 2 der DE-A 27 18 259) oder 4,6,4',6'-Tetrakis-trichlormethyl-2,2'-p-phenylen-bis-[1,3,5]triazin, hergestellt gemäß dem in der DE-A angegebenen Verfahren, ersetzt wurde.

Der Versuch, eine Beschichtungslösung entsprechend der in Beispiel 6 angegebenen Zusammensetzung herzustellen, mißlang, da die säurebildende Verbindung in der in Beispiel 6 angegebenen Konzentration keine ausreichende Löslichkeit im Resistlösemittel aufweist. Erst eine deutlich verringerte Konzentration des photoaktiven Säurebildners führt zu einer homogenen Beschichtungslösung. Diese Resistformulierungen zeigten jedoch eine wesentlich verringerte Empfindlichkeit (> 10 mJ/cm²) gegenüber den erfindungsgemäßen Gemischen.

Verschiedene Versuche der Bestrahlung eines - mit einer Beschichtungslösung nach Beispiel 7 - beschichteten Wafers zeigten deutliche Unterschiede in den Lichtempfindlichkeiten. Diese Sensitivitätsschwankungen bewegten sich in der Größenordnung von ±5% bis ±10%. Analytische Untersuchungen der Beschichtungslösung mit HLPC (High-pressure-liquid-chromatography) vor und nach dem Trocknungsprozeß (Softbake) - ohne nachfolgenden Belichtungsschritt - zeigten, daß beträchtliche Mengen der säurebildenden Verbindung aus der Schicht ausdampften. Dieses Verhalten macht die für eine praxisgerechte Prozeßführung erforderliche Kontrolle der Lichtempfindlichkeit nahezu unmöglich. Bei vergleichbaren Untersuchungen der erfindungsgemäßen strahlungsempfindlichen Gemische wurde ein solches Verhalten in keinem Fall beobachtet.

## Patentansprüche

1. Positiv arbeitendes strahlungsempfindliches Gemisch mit
a) einer Verbindung, die unter Einwirkung von aktinischer Strahlung starke Säure bildet,
b) einer Verbindung mit mindestens einer durch Säure spaltbaren C-O-C- oder C-O-Si-Bindung und
c) einem in Wasser unlöslichen, in wäßrigalkalischen Lösungen löslichen oder zumindest quellbaren polymeren Bindemittel,
dadurch gekennzeichnet, daß die Verbindung a) ein mit Sulfonsäure(n) der Formel R-SO₃H bzw. R'(-SO₃H)₂ verestertes 2,4-Bis-trichlormethyl-6-(mono- oder dihydroxyphenyl)-[1,3,5]triazin der allgemeinen Formeln I und/oder II ist 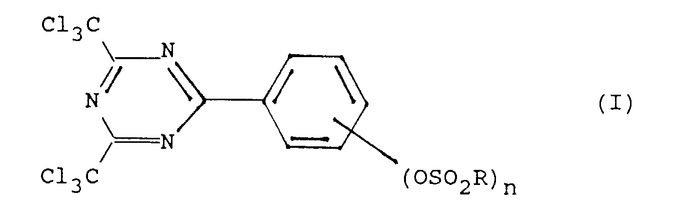 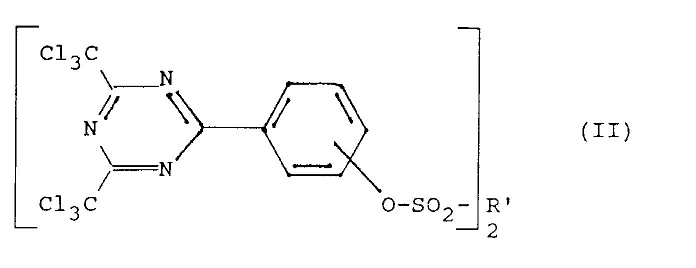 wobei R einen ggf. weiter substituierten (C₁-C₁₀)Alkyl-, (C₅-C₁₀)Cycloalkyl-, (C₆-C₁₀)Aryl-, (C₆-C₁₀)Aryl-(C₁-C₁₀)alkyl-, (C₃-C₉)Heteroarylrest, R' einen ggf. substituierten (C₁-C₁₀)Alkylen-, (C₆-C₁₀)Arylen- oder (C₃-C₉)Heteroarylenrest bezeichnet und n 1 oder 2 sein kann, wobei die besagten Substituenten (C₁-C₈)-Alkyl, (C₁-C₈)Alkoxy, (C₁-C₈)Alkanoyl, (C₁-C₈)Alkanoyloxy, (C₆-C₁₀)Aryl, Cyano oder Halogen sind.

2. Positiv arbeitendes strahlungsempfindliches Gemisch nach Anspruch 1, dadurch gekennzeichnet, dap die 2,4-Bis-trichlormethyl-6-(dihydroxyphenyl)-[1,3,5]triazine vollständig mit Sulfonsäuren R-SO₃H verestert sind.

3. Positiv arbeitendes strahlungsempfindliches Gemisch gemäß Anspruch 1 oder 2, dadurch gekennzeichnet, daß die Verbindung a) einen Anteil von 0,25 bis 15 Gew.-%, bevorzugt 0,5 bis 5 Gew.-%, am Gesamtgewicht der Feststoffe des Gemisches hat.

4. Positiv arbeitendes strahlungsempfindliches Gemisch gemäß einem oder mehreren der Ansprüche 1 bis 3, dadurch gekennzeichnet, daß die Verbindung b) mit mindestens einer durch Säure spaltbaren C-O-C- oder C-O-Si-Bindung einen Anteil von 1 bis 50 Gew.-%, bevorzugt 10 bis 40 Gew.-%, am Gesamtgewicht der Feststoffe des Gemisches hat.

5. Positiv arbeitendes strahlungsempfindliches Gemisch gemäß einem oder mehreren der Ansprüche 1 bis 4, dadurch gekennzeichnet, daß das Bindemittel c) für Strahlung der Wellenlänge 248 nm eine Extinktion von < 0,35 µm⁻¹, bevorzugt < 0,25 µm⁻¹, aufweist.

6. Positiv arbeitendes strahlungsempfindliches Gemisch gemäß einem oder mehreren der Ansprüche 1 bis 5, dadurch gekennzeichnet, daß das Bindemittel c) einen Anteil von 40 bis 95 Gew.-%, bevorzugt 50 bis 90 Gew.-%, am Gesamtgewicht der Feststoffe des Gemisches hat.

7. Positiv arbeitendes strahlungsempfindliches Aufzeichungsmaterial, bestehend aus einem Träger mit einer strahlungsempfindlichen Schicht, dadurch gekennzeichnet, daß die Schicht aus einem strahlungshärtbaren Gemisch gemäß einem oder mehreren der Ansprüche 1 bis 6 besteht.

## Claims

1. A positive-working radiation-sensitive mixture comprising
a) a compound which forms strong acid on exposure to actinic radiation,
b) a compound having at least one acid-cleavable C-O-C or C-O-Si bond, and
c) a water-insoluble polymeric binder which is soluble or at least swellable in aqueous alkaline solutions,
wherein the compound a) is an ester of a sulfonic acid or sulfonic acids of the formula R-SO₃H or R' (-SO₃H)₂ with 2,4-bistrichloromethyl-6-(mono- or dihydroxyphenyl)-1,3,5-triazine of the formulae I and/or II 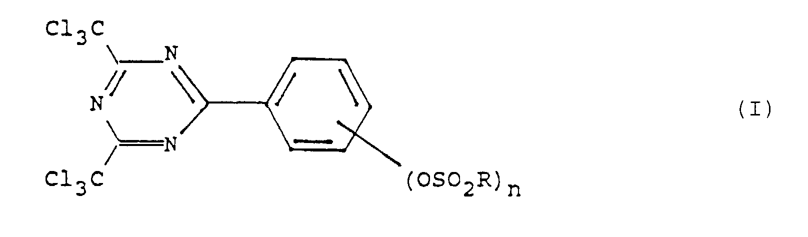 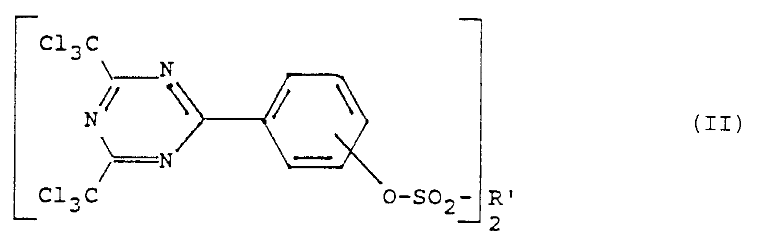 where R is an optionally further substituted (C₁-C₁₀)alkyl, (C₅-C₁₀)cycloalkyl, (C₆-C₁₀)aryl, (C₆-C₁₀)aryl-(C₁-C₁₀)alkyl or (C₃-C₉)heteroaryl radical, R' is an optionally substituted (C₁-C₁₀)alkylene, (C₆-C₁₀)arylene or (C₃-C₉)heteroarylene radical, and n may be 1 or 2, said substituents being (C₁-C₈)alkyl, (C₁-C₈)alkoxy, (C₁-C₈)alkanoyl, (C₁-C₈)alkanoyloxy, (C₆-C₁₀)aryl, cyano or halogen.

2. A positive-working radiation-sensitive mixture as claimed in claim 1, wherein the 2,4-bistrichloromethyl-6-(dihydroxyphenyl)-1,3,5-triazines are completely esterified with sulfonic acids R-SO₃H.

3. A positive-working radiation-sensitive mixture as claimed in claim 1 or 2, wherein the proportion of the compound a) is from 0.25 to 15 % by weight, preferably 0.5 to 5 % by weight, of the total weight of solids in the mixture.

4. A positive-working radiation-sensitive mixture as claimed in one or more of claims 1 to 3, wherein the proportion of the compound b) containing at least one acid-cleavable C-O-C or C-O-Si bond is 1 to 50 % by weight, preferably 10 to 40 % by weight, of the total weight of solids in the mixture.

5. A positive-working radiation-sensitive mixture as claimed in one or more of claims 1 to 4, wherein the binder c) has an absorbance of <0.35 µm⁻¹, preferably <0.25 µm⁻¹, for radiation of the wavelength 248 nm.

6. A positive-working radiation-sensitive mixture as claimed in one or more of claims 1 to 5, wherein the proportion of the binder c) is from 40 to 95 % by weight, preferably 50 to 90 % by weight, of the total weight of solids in the mixture.

7. A positive-working radiation-sensitive recording material composed of a base with a radiation-sensitive layer, wherein the layer is composed of a radiation-curable mixture as claimed in one or more of claims 1 to 6.

## Revendications

1. Composition sensible au rayonnement travaillant en positif avec
a) un composé qui forme un acide fort sous l'action de rayonnement actinique,
b) un composé avec au moins une liaison C-O-C ou C-O-Si clivable par un acide et
c) un liant polymère insoluble dans l'eau, soluble ou au moins capable de gonfler dans des solutions aqueuses alcalines,
caractérisée en ce que, le composé a) est une 2,4-bis-trichlorométhyl-6-(mono- ou dihydroxyphényl)-[1,3,5]-triazine, estérifiée avec un ou plusieurs acides sulfoniques de formule R-SO₃H ou R'(-SO₃H)₂, de formules générales I et/ou II 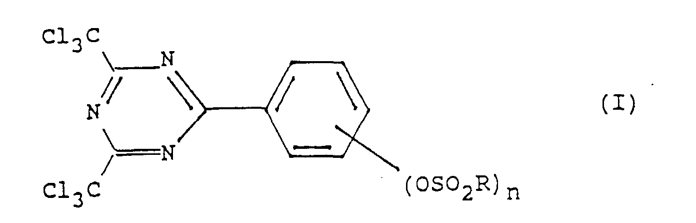 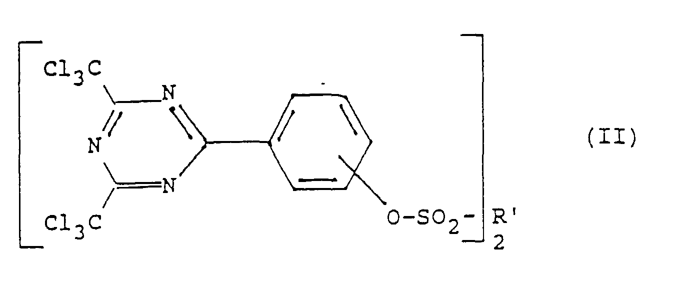 dans lesquelles R représente un groupe alkyle en C₁-C₁₀, cycloalkyle en C₅-C₁₀, aryle en C₆-C₁₀, aryle en C₆-C₁₀-alkyle en C₁-C₁₀, hétéroaryle en C₃-C₉ éventuellement de plus substitué, R' représente un groupe alkylène en C₁-C₁₀, arylène en C₆-C₁₀ ou hétéroarylène en C₃-C₉ éventuellement substitué et n peut être 1 ou 2, formules dans lesquelles les substituants indiqués sont un groupe alkyle en C₁-C₈, alcoxy en C₁-C₈, alcanoyle en C₁-C₈, alcanoyloxy en C₁-C₈, aryle en C₆-C₁₀, cyano ou un atome d'halogène.

2. Composition sensible au rayonnement travaillant en positif selon la revendication 1, caractérisée en ce que les 2,4-bis-trichlorométhyl-6-(dihydroxyphényl)-[1,3,5]-triazines sont complètement estérifiées avec des acides sulfoniques R-SO₃H.

3. Composition sensible au rayonnement travaillant en positif selon la revendication 1 ou 2, caractérisée en ce que le composé a) a une concentration de 0,25 à 15% en poids, de préférence de 0,5 à 5% en poids, du poids global des matières solides de la composition.

4. Composition sensible au rayonnement travaillant en positif selon une ou plusieurs des revendications 1 à 3, caractérisée en ce que le composé b) ayant au moins une liaison C-O-C ou C-O-Si clivable par un acide a une concentration de 1 à 50% en poids, de préférence de 10 à 40% en poids, du poids global des matières solides de la composition.

5. Composition sensible au rayonnement travaillant en positif selon une ou plusieurs des revendications 1 à 4, caractérisée en ce que le liant c) présente pour le rayonnement de longueur d'onde 248 nm un coefficient d'extinction < 0,35 µm⁻¹, de préférence < 0,25 µm⁻¹.

6. Composition sensible au rayonnement travaillant en positif selon une ou plusieurs des revendications 1 à 5, caractérisée en ce que le liant c) a une concentration de 40 à 95% en poids, de préférence de 50 à 90% en poids, du poids global des matières solides de la composition.

7. Matériel d'enregistrement sensible au rayonnement travaillant en positif, constitué d'un support avec une couche sensible au rayonnement, caractérisé en ce que la couche est constituée d'une composition durcissable sous l'action du rayonnement selon une ou plusieurs des revendications 1 à 6.
